Europäisches Patentamt

European Patent Office

Office européen des brevets

(19)

(11) Numéro de publication: **0 236 639 B1**

## FASCICULE DE BREVET EUROPEEN

(45) Date de publication du fascicule du brevet:
**14.03.90**

(21) Numéro de dépôt: **86402329.6**

(22) Date de dépôt: **16.10.86**

(51) Int. Cl.⁴: **C23C 14/56, C23C 16/54, C23C 8/36**

(54) **Installation flexible automatisée de traitement thermochimique rapide.**

(30) Priorité: **12.02.86 FR 8601913**

(43) Date de publication de la demande:
**16.09.87 Bulletin 87/38**

(45) Mention de la délivrance du brevet:
**14.03.90 Bulletin 90/11**

(84) Etats contractants désignés:
**AT BE CH DE GB IT LI LU NL SE**

(73) Titulaire: **STEIN HEURTEY, Z.A.I. du Bois de l'Epine BP No 69, F-91130 Ris Orangis(FR)**

(72) Inventeur: **Bourel, Jean, 34, allée des Ormes, F-94170 Le Perreux S/Marne(FR)**
Inventeur: **Lebeaupin, Denis, 1, rue Alfred Savouré, F-94220 Charenton(FR)**
Inventeur: **Schweibel, Olivier, 2, Square de la Borne, F-91000 Courcouronnes(FR)**

(74) Mandataire: **Armengaud Alné, Alain, Cabinet ARMENGAUD AINE 3 Avenue Bugeaud, F-75116 Paris(FR)**

(56) Documents cités:
EP-A- 0 144 229
FR-A- 2 165 849
FR-A- 2 183 557
FR-A- 2 403 645
FR-A- 2 526 813
US-A- 4 405 435

PATENT ABSTRACTS OF JAPAN,
vol. 8, no. 130 (C-229)[1567], 16 juin 1984; &
JP-A-59 41 470 (SHIMAZU SEISAKUSHO
K.K.) 07-03-1984
PATENT ABSTRACTS OF JAPAN,
vol. 7, no. 204 (E-197)[1349], 9th September 1983; &
JP-A-58 101 478 (TOKYO SHIBAURA DENKI
K.K.) 16-06-1983
PATENT ABSTRACTS OF JAPAN,

(56) Documents cités: (suite)
vol. 8, no. 11 (C-205)[1448], 18 janvier 1984; &
JP-A-58 180 227 (SAMUKO INTERNATIONAL
KENKYUSHO K.K.) 21-10-1983
PATENT ABSTRACTS OF JAPAN,
vol. 5, no. 45 (C-48)[717], 25 mars 1981; &
JP-A-56 274 (HITACHI SEISAKUSHO K.K.) 06-01-1981
PATENT ABSTRACTS OF JAPAN,
vol. 9, no. 5 (C-260)[1728], 10 janvier 1985; &
JP-A-59 157 281 (TOKUDA SEISAKUSHO
K.K.) 06-09-1984

## Description

La présente invention est relative à une installation flexible de traitement thermochimique rapide.

On sait que, en vue d'augmenter la dureté et la résistance à la fatigue des pièces utilisées dans l'industrie mécanique, on fait subir à celles-ci un traitement thermochimique qui consiste à enrichir la matière de ces pièces avec des espèces chimiques choisies, par exemple du carbone ou de l'azote, puis à les refroidir selon des cycles connus.

Les installations actuellement utilisées pour effectuer ce type de traitement sont généralement réalisées sous la forme de lignes continues ou de fours à charge. Dans ces installations, on effectue le chauffage et le traitement thermochimique dans une même chambre, la trempe étant faite par immersion dans un bac relié au four par un sas. Les pièces à traiter sont disposées sur des plateaux, dans des paniers ou sur des tapis, qui représentent couramment 50 % de la charge totale du four.

Les installations connues présentent notamment les contraintes et inconvénients suivants :

1o – dispersion de la qualité des pièces traitées, du fait de la difficulté d'obtenir une bonne homogénéité de température et de distribution du gaz actif dans la charge ;

2. – longueur des cycles, pour les enrichissements de faible épaisseur liée à l'emploi de moyens conventionnels de chauffage, convection-rayonnement, et à la recherche d'un minimum d'homogénéité;

3. – risques, en cas d'incident de fonctionnement, de voir rebuté la charge ou le contenu entier du four, selon le cas;

4. – risques d'explosion importante, liés à la dimension des fours, aux atmosphères utilisées et aux bacs de trempe;

5. – coût d'exploitation grevé, d'une part, par la surconsommation nécessaire au chauffage conjoint des paniers, plateaux ou tapis, et à la masse des réfractaires des fours, et, d'autre part, par le renouvellement cyclique de ces matériels de conditionnement fabriqués en alliages nobles;

6. – manque de flexibilité des installations, les fours étant dimensionnés pour les charges les plus lourdes et les plus volumineuses, et étant donc surcapacitaires et mal adaptés à des charges différentes du point de vue thermique et aérodynamique;

7. – difficulté, dans le cas des lignes continues, de diminuer la dispersion de qualité et la longueur des cycles, les pièces en préchauffage et celles au stade de la diffusion cohabitant dans la même enceinte.

Ces contraintes et inconvénients, et le fait que de telles installations doivent être conduites par un personnel spécialisé, font qu'il n'est pas facilement envisageable de les intégrer dans des lignes d'usinage de fabrication de grande série de pièces mécaniques.

On connaît par ailleurs (EP-A 0 144 229 et JPA 5 941 470) des installations de traitement comprenant des chambres de traitement, des moyens pour y introduire et en évacuer les pièces à traiter, un sas de transfert et des moyens de manipulation assurant le transfert des pièces entre les chambres de traitement par passage au travers du sas. Cependant, de telles installations ne permettent pas pour les motifs précisés au-dessus, de traiter en continu des pièces mécaniques.

L'invention concerne, en conséquence, une installation conçue de manière à ne pas présenter les inconvénients des installations connues, spécifiées ci-dessus.

Cette invention a donc pour objet une installation automatique de traitement thermochimique rapide de pièces, destinées à l'industrie mécanique qui comprend une pluralité d'enceintes de traitements de pièces telles que notamment enceintes de préchauffage, enceinte de traitement thermochimique, enceinte de trempe, un sas de transfert; un transporteur pour délivrer à l'installation les pièces à traiter empilées en colonnes; un robot d'alimentation délivrant successivement chaque colonne de pièces à un poste de chargement situé sur le sas de transfert et constitué d'une potence portant une coupole mobile venant coiffer la colonne de pièces en formant une chambre étanche de chargement, sa face plane inférieure servant de porte de sas vers le sas de transfert, et portant le support de la colonne de pièces; et un robot de manipulation placé dans ledit sas de transfert pour assurer les transferts successifs des pièces à traiter entre les différentes de traitement, ce robot étant constitué d'un bras déplaçable dans le sas de transfert, portant à son extrémité un plateau sur lequel repose un support de la colonne de pièces, ce support étant conçu de façon à assurer l'étanchéité de chaque enceinte de traitement vis-à-vis du sas de transfert.

On comprend que, selon l'invention, chacune des étapes d'un cycle de traitement thermochimique des pièces est exécutée dans l'un desdits modules de traitement, dont les caractéristiques peuvent être optimisées en fonction de son rôle spécifique dans le cycle, par exemple:

– transfert thermique, avec adaptation aux modes de transfert;
– transfert de masse ou trempe.

Le cycle complet comporte des étapes de durées différentes, du fait des cinétiques en jeu (vitesses de diffusion d'expèces chimiques différentes des vitesses de diffusion de la chaleur au travers de la surface), l'étape la plus courte du cycle (étape de base) déterminant la capacité d'un module. Selon l'invention, pour chaque étape successive du traitement, le nombre de modules est, en nombre entier, proportionnel au rapport du temps de l'étape considérée sur le temps de l'étape de base.

L'invention concerne également des modes d'utilisation de l'installation automatique de traitement thermochimique rapide, définie ci-dessus.

Selon une caractéristique de cette invention, les pièces qui arrivent en continu d'une ligne de fabrication sont empilées en colonnes, sur lesquelles elles peuvent être séparées par des intercalaires, et elles sont délivrées, à l'aide d'un robot, au poste correspondant du sas de chargement, où une coupole vient coiffer la colonne pour l'enfermer de façon étanche, la colonne de pièces étant ensuite transférée au premier module de traitement, par exemple le module de préchauffage, par l'intermédiaire du sas de transfert et du moyen de manipulation des pièces.

Selon l'invention, le sas de transfert peut être une chambre de section circulaire sur le pourtour de laquelle sont répartis les différents modules, ou une chambre de section rectangulaire le long de laquelle sont disposés les modules, la disposition étant fonction de l'implantation et de la prévision du travail.

D'autres caractéristiques et avantages de cette invention ressortiront de la description faite ci-après en référence aux dessins annexés, qui en illustrent deux exemples de réalisation dépourvus de tout caractère limitatif. Sur les dessins :

— la Figure 1 est une vue en élévation et en coupe verticale d'un premier exemple de réalisation d'une installation selon cette invention, comportant un sas de transfert de section circulaire ;
— la Figure 2 est une vue en plan de la Figure 1 ;

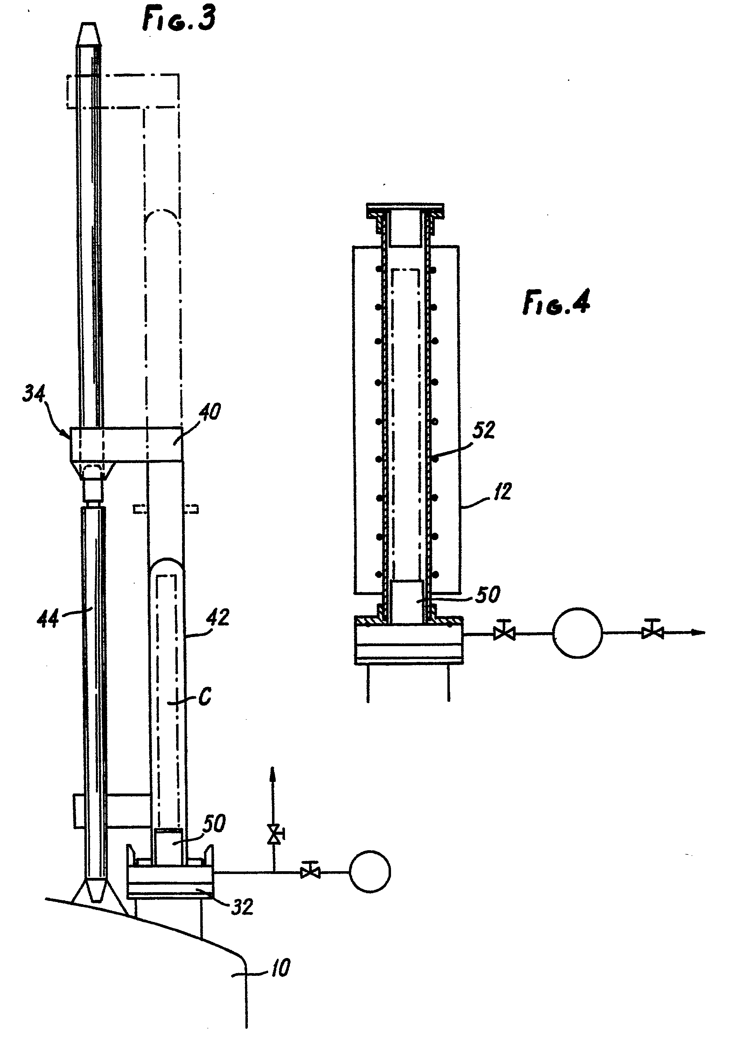

— la Figure 3 est une vue partielle représentant le poste de chargement/déchargement de l'installation des Figures 1 et 2 ;
— la Figure 4 est une vue de détail illustrant, en coupe verticale, le module de préchauffage de l'installation ;
— la Figure 5 est une vue en élévation latérale et arrachement partiel d'un second exemple de réalisation d'une installation conforme à l'invention, comportant un sas de transfert de section rectangulaire ;
— la Figure 6 est une coupe de la Fig. 5 par un plan vertical transversal.

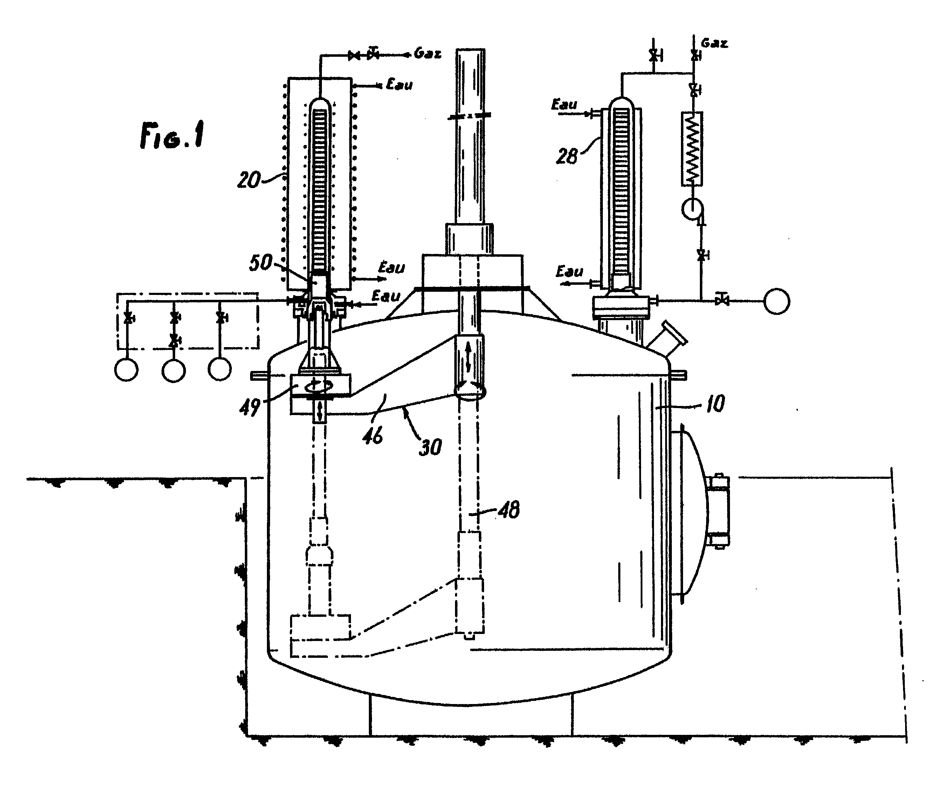

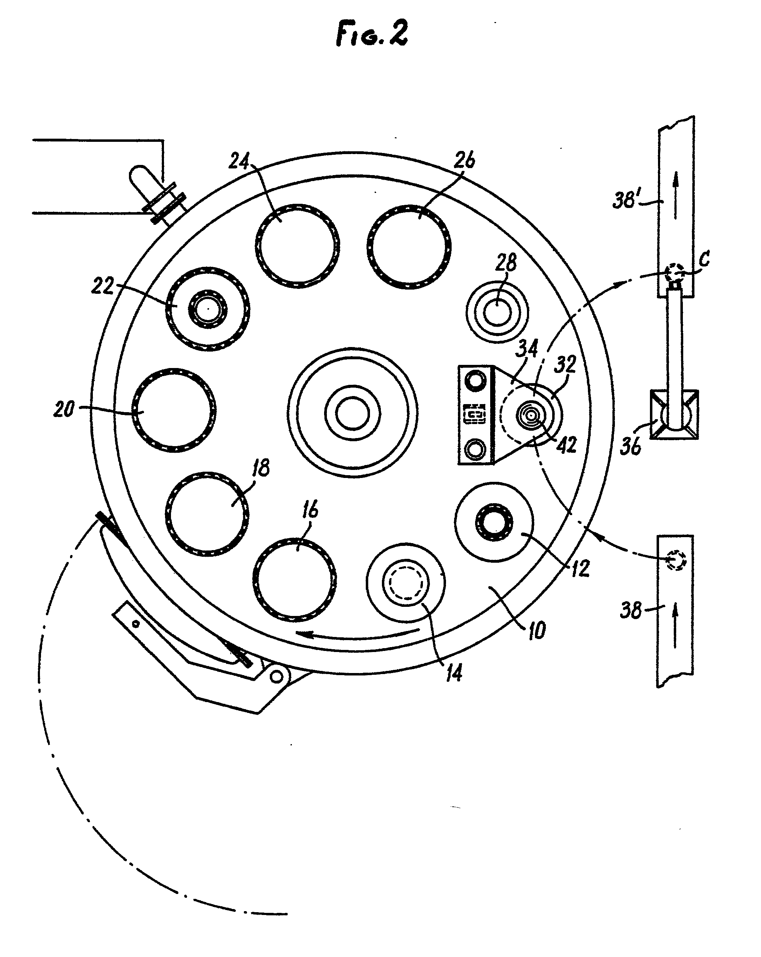

En se référant aux Figures 1 et 2, on voit que l'installation selon l'invention comprend essentiellement les éléments suivants :

— un sas de transfert 10, qui, dans cet exemple de réalisation, se présente sous la forme d'une enceinte de section circulaire ;
— une pluralité de modules de traitement des pièces, comprenant par exemple des modules de préchauffage 12, 14, des modules de cémentation/diffusion 16 à 26, et un module de trempe sous atmosphère contrôlée 28, tous ces modules étant montés sur la paroi supérieure du sas de transfert et étant connectés à ce sas ;
— un moyen de manipulation 30, placé dans le sas de transfert 10 et conçu de façon à assurer le transfert des pièces à traiter entre les différents modules ;
— un poste de chargement/déchargement 34 des pièces, avec son sas 32 et sa coupole mobile 42 ; et,
— un robot d'alimentation 36 pour amener les pièces à l'installation.

Les pièces, qui arrivent en continu d'une ligne de fabrication, sont empilées en colonne C, sur laquelle elles peuvent être séparées par des intercalaires. Les colonnes C de pièces peuvent être amenées à l'installation à l'aide d'un convoyeur 38, à partir duquel elles sont reprises par le robot d'alimentation 36, qui délivre successivement chaque colonne C au poste de chargement 34. Ce poste de chargement 34 se compose, par exemple, d'une potence 40, pouvant se déplacer verticalement le long d'une tige 44, et qui porte la coupole mobile 42. Cette coupole 42 vient coiffer la colonne de pièces C, afin de l'enfermer de façon étanche. L'enceinte délimitée par la coupole est ensuite mise sous une atmosphère et une pression identiques à celles régnant dans le sas de transfert 10, le volume réduit de cette enceinte permettant une purge rapide.

Le moyen de manipulation, ou robot de manipulation 30, assure ensuite le transfert de la colonne C successivement aux différents modules de traitement, par l'intermédiaire du sas de transfert 10.

Ce sas de transfert est constitué par une enceinte dont la paroi interne possède une faible émissivité, afin de minimiser les échanges par rayonnement thermique, lors des transferts des colonnes de pièces. Il est mis sous atmosphère neutre, afin de minimiser les risques d'oxydation, d'explosion, et/ou sous basse pression pour réduire les échanges par convection.

Le robot de manipulation 30, placé dans le sas de transfert 10, se présente sous la forme d'un bras 46, pouvant tourner autour d'une colonne centrale 48, le long de laquelle il peut en outre se déplacer. Ce bras 46 porte à son extrémité un plateau 49, sur lequel repose le support 50 de la colonne de pièces C, ce support étant conçu de manière à assurer l'étanchéité de chaque module de traitement par rapport au sas de transfert 10.

La colonne de pièces C ayant été amenée au module de préchauffage 12, celui-ci, fermé de façon étanche, est alors rempli de gaz à la pression désirée. Dans cet exemple de réalisation, on utilise un chauffage par inducteurs 52, qui offre l'avantage de la rapidité. On peut cependant utiliser tout autre moyen de préchauffage ou traitement. Dès que la température de traitement a été atteinte, le module 12 est purgé à la pression et à l'atmosphère identiques à celles du sas de transfert 10, et la colonne C est transférée au module suivant.

Dans cet exemple de réalisation non limitatif, on a prévu deux modules de préchauffage 12, 14, afin d'obtenir une meilleure homogénéité : dans le premier module 12, on effectue un préchauffage en-dessous du point de Curie, et, dans le second module 14, on effectue un préchauffage à une température supérieure au point de Curie. Les fréquences d'alimentation des inducteurs 52 sont choisies de manière à obtenir le mode de chauffage visé : soit un chauffage localisé aux surfaces à enrichir, soit un chauffage dans la masse. Les fréquences d'alimentation, et la nécessité de scinder le chauffage en deux étapes (donc de prévoir deux modules), sont déterminées par des essais préliminaires. Chaque module de préchauffage peut être équipé d'une distribution de gaz, afin de procéder à une réduction des oxydes superficiels et/ou à un dégraissage des pièces, au cours de ce préchauffage.

Le préchauffage en une ou deux étapes étant terminé, le robot de manipulation 30 transfère ensuite la colonne C au module en attente de traitement thermochimique 16 à 26. Celui-ci est étanche, et il est mis sous pression appropriée du gaz choisi.

Dans chacun des modules de traitement thermochimique 16-26, l'enrichissement des pièces est obtenu par circulation du gaz, les pièces étant maintenues à la température désirée. En fin de phase d'enrichissement, l'atmosphère du module est purgée et remplacée par celle nécessaire à la diffusion. En fin de diffusion, l'atmosphère du module est purgée et remplacée par une atmosphère identique, en pression et composition, à celle du sas de transfert 10, de manière que le robot de manipulation 30 puisse transporter la colonne de pièces au module suivant.

Le traitement thermochimique peut être effectué, au choix, sous des pressions de valeurs réduites, quelques millibars absolus, à des pressions supérieures à la pression atmosphérique, quelques bars absolus, par exemple.

Dans les deux cas, les distributions de gaz peuvent être déterminées à partir d'essais, en fonction de la pression, du type de pièces à traiter et de la hauteur des colonnes de pièces.

Les concentrations de gaz d'apport sont fixées à partir d'expériences corrélées selon des équations d'échanges thermique et massique prenant en compte l'aérodynamique de la chambre, la cinétique de réaction du gaz et les paramètres thermodynamiques d'équilibre.

Cet enrichissement de la pièce peut être effectué de manière continue, la proportion de gaz d'apport étant régulée par un automate program mable. La quantité de gaz d'apport est une fonction du temps, déterminée comme précisé ci-dessus.

Pour améliorer le renouvellement des espèces réactives, il est possible de travailler en alimentant le module de gaz d'apport par bouffées. La fréquence de ces bouffées est déterminée par des expériences, et corrélée en fonction des différents paramètres : nature du gaz, concentration, volume, température, dimension de la chambre. Il est possible d'opérer un traitement ionique, les pièces étant alors à la cathode et l'enceinte à l'anode.

La diffusion de l'espèce chimique dans les pièces s'opère dans le même module, de préférence sous vide, ou, éventuellement, sous atmosphère neutre ou atmosphère régulée de gaz d'apport.

A la fin du traitement thermochimique, le robot de manipulation 30 transporte la colonne de pièces au module de trempe 28. La trempe des pièces peut être effectuée par convection de gaz froid, brouillard, ou impact de jet liquide, ou solution hybride de ces trois moyens, le fluide de trempe circulant dans le module. Les paramètres qui règlent l'échange, à savoir :
- la nature du gaz, sa température, sa vitesse dans le module et sa distribution ;
- la nature du brouillard, sa vitesse de passage, les dimensions et proportions des gouttelettes ;
- la grosseur des gouttes, la distance entre les buses d'éjection et les pièces,
sont déterminés expérimentalement.

Dans le cas d'un échange mettant en jeu un liquide plus ou moins dispersé, lors de la dernière partie du refroidissement, le module et ses périphériques sont séchés en utilisant les calories cédées par les pièces à refroidir.

Le module peut être pourvu d'une enceinte à double paroi ; celle-ci est parcourue par un liquide réfrigérant qui permet de refroidir les pièces par rayonnement, ce qui est rendu possible grâce à la disposition en colonne des pièces.

En fin de trempe, le module 28 est purgé, mis sous une atmosphère identique à celle du sas 10, et la colonne est reprise par le robot de manipulation 30 pour être transférée au module de chargement/déchargement 32, d'où elle est évacuée par le robot de déchargement 36 et le convoyeur d'évacuation 38'.

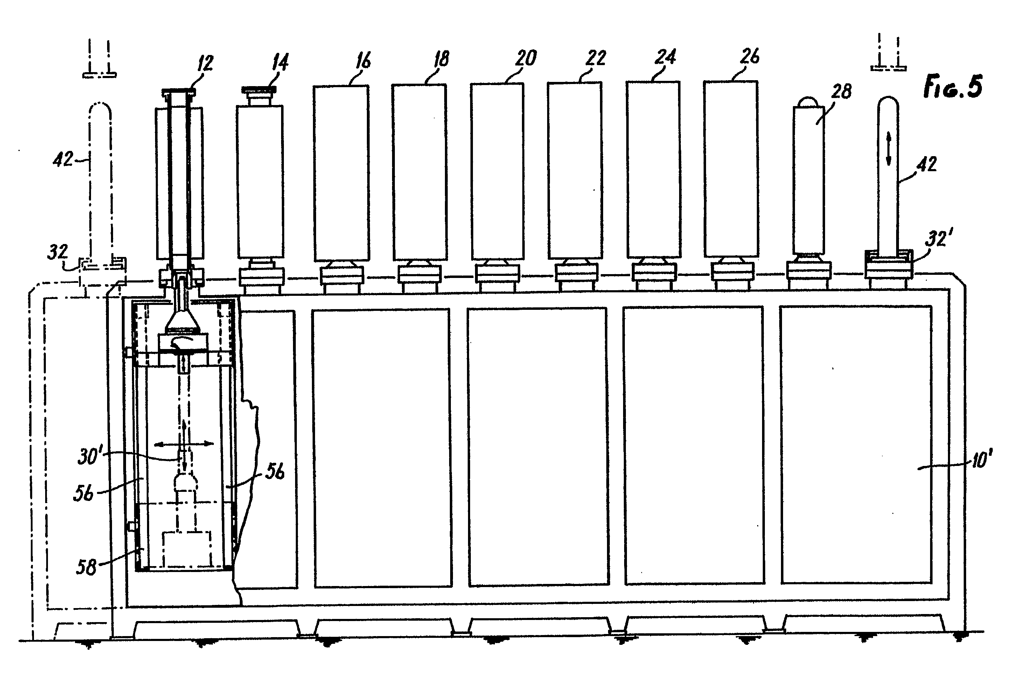

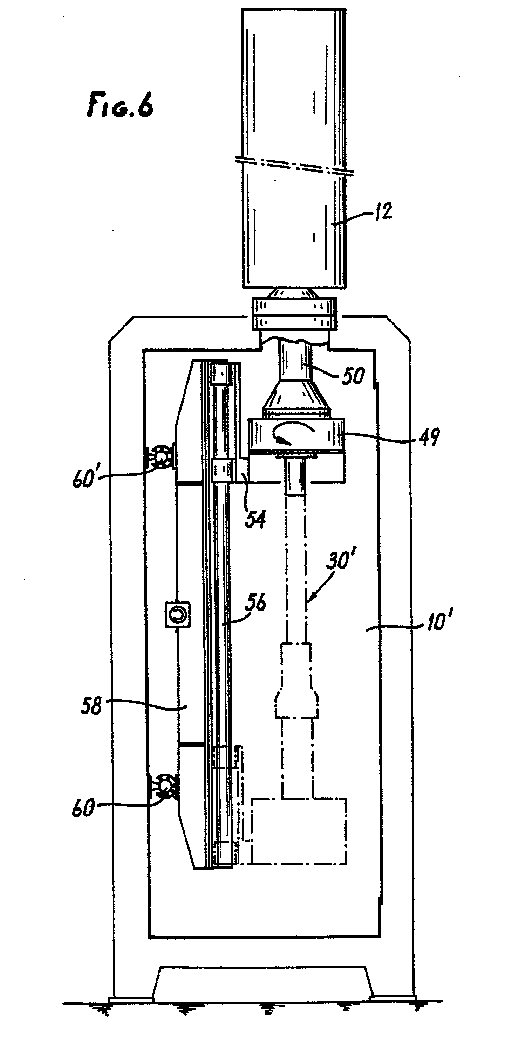

Dans la variante représentée sur les Figures 5 et 6, on retrouve les mêmes éléments constitutifs que ceux de l'installation décrite ci-dessus, la différence essentielle étant que le sas de transfert 10' est constitué d'une enceinte à section rectangulaire, sur le sommet de laquelle sont alignés les différents modules.

Dans cette variante, le robot de manipulation 30', qui assure le transfert des colonnes de pièces entre les différents modules 12-28, depuis le module de chargement 32 jusqu'au module de déchargement 32', se présente sous la forme d'un bras 54, coulissant le long de colonnes verticales 56, portées par un chariot vertical 58 se déplaçant transversalement tout le long du sas 10', grâce aux voies de roulement 60, 60', les autres éléments de ce robot étant identiques à ceux du robot manipulateur 30 décrit ci-dessus.

On conçoit que, dans une installation selon cette invention, chaque module ou série de modules est adapté, en taille et géométrie, au type des pièces à traiter, un changement de type de pièces, hors d'une certaine tolérance, ne nécessitant qu'un simple changement de modules. Ceci apporte en particulier les avantages suivants :
- flexibilité vis à vis de la production ;
- l'adaptation des modules aux pièces entraîne une amélioration de la qualité, par une meilleure homogénéité de température ;
- obtention d'une meilleure distribution des gaz ;
- le traitement par lots en colonnes permet l'emploi de l'induction en tant que moyen de chauffage, ce qui n'est pas possible dans les fours conventionnels ;
- en cas d'incident, seule une fraction de la production est perturbée, et non la charge entière de l'installation ;
- les risques d'explosion sont supprimés par rapport aux installations conventionnelles, puisque :
. l'amélioration de l'aérodynamique de l'ensemble charge-module permet une utilisation efficace des trempes au gaz et/ou brouillard, et rend donc la trempe à l'huile moins nécessaire ;
. d'autre part, le fractionnement des charges diminue les volumes de gaz explosif ; ces volumes se circonscrivent, en effet, aux espaces laissés libres dans les modules de traitement thermochimique, volume entre les pièces et les parois ;
. le fractionnement par lots permet la mise en oeuvre des techniques dites basse pression, qui réduisent encore les risques d'explosion ;

- l'amélioration des vitesses de refroidissement en utilisant He ou H2, utilisation rendue possible par les dimensions réduites de la chambre ;
- les coûts d'exploitation sont diminués par rapport aux installations conventionnelles, puisque les supports des colonnes ont un poids relatif très inférieur à celui des plateaux ou paniers, dans les installations ordinaires ;
- ces coûts sont diminués, puisque il n'y a plus à chauffer une chambre de grande dimension avec ses réfractaires ;
- ces coûts sont diminués, puisque la géométrie de l'installation suit au mieux la géométrie des pièces, et évite la surcapacité de celle-ci ;
- toutes les pièces traitées dans une même enceinte ont le même "vécu", ce qui évite les problèmes de gestion d'atmosphère.

Il demeure bien entendu que cette invention n'est pas limitée aux exemples de réalisation décrits et/ou représentés, mais qu'elle en englobe toutes les variantes. C'est ainsi qu'en particulier, on peut envisager d'autres géométries et dispositions, en ce qui concerne l'installation automatisée objet de cette invention, notamment, les modules de traitement des pièces peuvent être mobiles sur un carrousel, l'alimentation étant fixe.

## Revendications

1. Installation automatique de traitement thermochimique rapide de pièces, destinées à l'industrie mécanique qui comprend une pluralité d'enceintes de traitements (12–28) de pièces telles que notamment enceintes de préchauffage (12, 14), enceinte de traitement thermochimique (16–24), enceinte de trempe (28), un sas de transfert (10, 10'); un transporteur (38) pour délivrer à l'installation les pièces à traiter empilées en colonnes (C); un robot d'alimentation (36) délivrant successivement chaque colonne de pièces (C) à un poste de chargement (34) situé sur le sas de transfert (10), et constitué d'une potence (40) portant une coupole mobile (42) venant coiffer la colonne de pièces (C) en formant une chambre étanche de chargement, sa face plane inférieure servant de porte de sas (32) vers le sas de transfert (10–10'), et portant le support (50) de la colonne de pièces; et un robot de manipulation (30) placé dans ledit sas de transfert (10) pour assurer les transferts successifs des pièces à traiter entre les différentes enceintes de traitement (12–28), ce robot étant constitué d'un bras (46) déplaçable dans le sas de transfert, portant à son extrémité un plateau (49) sur lequel repose un support (50) de la colonne de pièces, ce support étant conçu de façon à assurer l'étanchéité de chaque enceinte de traitement vis-à-vis du sas de transfert.

2. Installation selon la revendication 1, caractérisé en ce que le bras (46) du robot de manipulation (30) peut tourner autour d'une colonne centrale (48), le long de laquelle il peut en outre se déplacer verticalement.

3. Installation selon la revendication 1, caractérisée en ce que le bras (54) du robot de manipulation (30') peut coulisser le long de colonnes verticales (56) portées par un chariot vertical (58) qui se déplace transversalement le long du sas de transfert (10') grâce à des voies de roulement (60, 60').

4. Installation selon l'une quelconque des revendications précédentes, caractérisée en ce que le sas de transfert (10) est constitué d'une chambre de section circulaire, sur le pourtour de laquelle sont réparties les différentes enceintes de traitement.

5. Installation selon l'une quelconque des revendications 1 à 3, caractérisée en ce que le sas de transfert (10') est constitué d'une chambre de section rectangulaire, le long de laquelle sont disposées les différentes enceintes de traitement.

6. Utilisation d'une installation telle que définie dans l'une quelconque des revendications précédentes pour la mise en œuvre d'un procédé de traitement thermochimique rapide dans lequel le nombre d'enceintes de traitement est défini pour chacune des étapes de traitement correspondant par rapport à la production recherchée des pièces traitées.

7. Utilisation selon la revendication 6, caractérisée en ce que le traitement de préchauffage est effectué en une seule étape dans une enceinte unique de préchauffage.

8. Utilisation selon la revendication 6, caractérisé en ce que le traitement de préchauffage est effectué en deux étapes: une première étape qui correspond aux températures inférieures à celles du point de Curie et une seconde étape correspondant aux températures supérieures à celles du point de Curie.

## Patentansprüche

1. Automatische Vorrichtung zur schnellen thermo-chemischen Behandlung von für die mechanische Industrie bestimmten Teilen, die mehrere Behandlungskammern (12 bis 28) für Teile, wie insbesondere Kammern zum Vorerhitzen (12, 14), eine Kammer zur thermo-chemischen Behandlung (16 bis 24), eine Abschreckkammer (28) und eine Durchlaßschleuse (10, 10'); eine Transportvorrichtung (38) zum Zuführen der zu behandelnden, in Form von Säulen (C) aufgestapelten Teilen zur Vorrichtung; einen Zuführungsroboter (36), welcher nach und nach jede Säule aus Teilen (C) einer in der Durchlaßschleuse (10) angeordneten Beladungsstation (34) zuführt und aus einem Arm (40) besteht, der eine bewegliche Kuppel (42) trägt, die gegen die Säule aus Teilen (C) in Anlage kommt und dabei eine dichte Beladungskammer bildet, deren untere plane Seite gegenüber der Durchlaßschleuse (10, 10') als Schleusentor (32) dient und den Träger (50) für die Kolonne aus Teilen trägt; und einen Bedienungsroboter (30) besitzt, welcher in der Durchlaßschleuse (10) angeordnet ist, um die aufeinander folgenden Überführungen der zu behandelnden Teile zwischen den verschiedenen Behandlungskammern (12 bis 28) sicherzustellen, wobei dieser Roboter aus einem in der Durchlaßschleuse verschiebbaren Arm (46) besteht, der an seinem Ende eine Platte (49) besitzt, auf der ein Träger (50) für die Kolonne aus Teilen ruht, wobei dieser Träger (50) für die Kolonne aus Teilen ruht, wobei dieser Träger derart ausgestaltet ist, daß er die Abdichtung jeder Behandlungskammer gegen die Durchlaßschleuse sicherstellt.

2. Vorrichtung nach Anspruch 1, dadurch gekennzeichnet, daß der Arm (46) des Bedienungsroboters (30) um eine zentrale Säule (48) drehen kann, entlang derer er sich außerdem vertikal verschieben kann.

3. Vorrichtung nach Anspruch 1, dadurch gekennzeichnet, daß der Arm (54) des Bedienungsroboters (30') entlang den vertikalen Säulen (46) gleiten kann, die von einem vertikalen Schlitten (58) getragen werden, der sich mit Hilfe von Laufbahnen (60, 60') quer entlang der Durchlaßschleuse (10') verschiebt.

4. Vorrichtung nach einem der vorhergehenden Ansprüche, dadurch gekennzeichnet, daß die Durchlaßschleuse (10) aus einem Raum mit kreisförmigem Querschnitt besteht, auf dessen Umfang die verschiedenen Behandlungskammern verteilt sind.

5. Vorrichtung nach einem der Ansprüche 1 bis 3, dadurch gekennzeichnet, daß die Durchlaßschleuse (10') aus einem Raum mit rechteckigem Querschnitt besteht, entlang dessen die verschiedenen Behandlungskammern angeordnet sind.

6. Verwendung einer wie in einem der vorhergehenden Ansprüche definierten Vorrichtung zur Durchführung eines schnellen thermo-chemischen Behandlungsverfahrens, bei dem die Zahl der Behandlungskammern für jede der Stufen der entsprechenden Behandlung bezüglich der gewünschten Produktion an behandelten Teilen definiert wird.

7. Verwendung nach Anspruch 6, dadurch gekennzeichnet, daß die Behandlung zum Vorerhitzen in einer einzigen Stufe in nur einer Vorerhitzungskammer durchgeführt wird.

8. Verwendung nach Anspruch 6, dadurch gekennzeichnet, daß die Vorerhitzungsbehandlung in zwei Stufen durchgeführt wird: Eine erste Stufe, die denjenigen Temperaturen entspricht, die niedriger sind als diejenigen des Curie-Punktes, und eine zweite Stufe, die denjenigen Temperaturen entspricht, die höher sind als diejenigen des Curie-Punktes.

## Claims

1. Automatic installation for the rapid thermochemical treatment of components intended for the mechanical engineering industry, which comprises a plurality of treatment containers (12–28) for components such as, notably, preheating containers (12, 14), thermochemical treatment container (16–24), quenching container (28), a transfer lock chamber (10, 10'); a conveyor (38) for delivering to the installation the components to be treated stacked in columns (C); a feed robot (36) delivering successively each column of components (C) to a charging station (34) situated on the transfer lock chamber (10) and constituted of a jib (40) carrying a movable dome (42) for capping the column of components (C) by forming a leak-tight charging chamber, its lower plane face serving as lock gate (32) towards the transfer lock (10, 10') and carrying the support (50) for the column of components; and a handling robot (30) placed in said transfer lock chamber (10) for assuring the successive transfers of the components to be treated between the different treatment containers (12–28), this robot being constituted of an arm (46) movable in the transfer lock chamber and carrying, at its end, a plate (49), on which a support (50) for the column of components rests, this support being designed in such a way as to assure the sealing of each treatment container with respect to the transfer lock chamber.

2. Installation according to Claim 1, characterized in that the arm (46) of the handling robot (30) can revolve about a central column (48), along which it can in addition move vertically.

3. Installation according to Claim 1, characterized in that the arm (54) of the handling robot (30') can slide along vertical columns (56) carried by a vertical carriage (58), which moves transversely along the transfer lock chamber (10') by means of roller tracks (60, 60').

4. Installation according to any one of the preceding Claims, characterized in that the transfer lock chamber (10) is composed of a chamber of circular section, on the periphery of which the various treatment containers are distributed.

5. Installation according to any one of Claims 1 to 3, characterized in that the transfer lock chamber (10') is constituted of a chamber of rectangular section, along which the different treatment containers are disposed.

6. Use of an installation as defined in any one of the preceding Claims for the carrying out of a rapid thermochamical treatment method, in which the number of treatment containers is defined for each of the corresponding treatment steps in proportion to the desired production rate of the components treated.

7. Use according to Claim 6, characterized in that the preheating treatment is carried out in a single step in a single preheating container.

8. Use according to Claim 6, characterized in that the preheating treatment is carried out in two steps: a first step which corresponds to the temperatures below the Curie point and a second step corresponding to the temperatures above the Curie point.

Fig.1

Gaz

Eau

20

50

Eau

Eau

49

46

30

48

Gaz

Eau

28

Eau

10

EP 0 236 639 B1

Fig. 2

Fig.3

Fig.4

Fig.5

EP 0 236 639 B1

Fig.6